# FASCICULE DE BREVET EUROPEEN

(11) **EP 3 844 327 B1**
(45) Date de publication et mention de la délivrance du brevet: **31.08.2022**
(21) Numéro de dépôt: 19817385.8
(22) Date de dépôt: 14.10.2019
(51) Int. Cl.: C30B 7/00, C30B 29/14

(54) **PROCÉDÉ DE FABRICATION D'UN MONOCRISTAL PAR CROISSANCE EN SOLUTION PERMETTANT UN PIÉGEAGE DE CRISTAUX PARASITES**
VERFAHREN ZUR HERSTELLUNG EINES EINKRISTALLS DURCH LÖSUNGSWACHSTUM ZUM EINFANGEN VON PARASITÄREN KRISTALLEN
METHOD FOR MANUFACTURING A SINGLE CRYSTAL BY SOLUTION GROWTH ENABLING TRAPPING OF PARASITIC CRYSTALS

(30) Priorité: 17.10.2018 FR 1859610
(43) Date de publication de la demande: 07.07.2021
(73) Titulaire: Commissariat à l'énergie atomique et aux énergies alternatives, 75015 Paris (FR)
(72) Inventeur: PINTAULT, Bruno, 37260 Monts (FR); BELOUET, Christian, 92330 Sceaux (FR)
(74) Mandataire: Brevalex
(86) Numéro de dépôt international: PCT/FR2019/052430
(87) Numéro de publication internationale: WO 2020/079356

(56) Documents cités:
- WO-A1-2018/007729
- US-A- 5 122 224

## Description

### DOMAINE TECHNIQUE

Le domaine de l'invention est celui de la production de monocristaux par croissance en solution à partir d'un germe cristallin.

L'invention concerne plus particulièrement un procédé limitant les effets d'une germination primaire ou secondaire dans une solution de croissance cristalline, dans le cadre de la production de monocristaux par croissance en solution saline.

### ÉTAT DE LA TECHNIQUE ANTÉRIEURE

Les monocristaux, et notamment les monocristaux de grandes dimensions de dihydrogénophosphate de potassium (KDP) ou de dihydrogénophosphate de potassium deutéré (DKDP), sont obtenus par croissance cristalline à partir d'un germe (c'est-à-dire le cristal initial à partir duquel la croissance commence) placé dans une solution sursaturée d'un sel de même nature que le germe. Des plaques, découpées dans ces monocristaux de KDP et de DKDP de grandes tailles, peuvent être utilisées pour réaliser des éléments optiques pour les lasers de puissance pour la fusion par confinement inertiel. Ces éléments optiques sont par exemple des cellules de Pockels ou des éléments optiques pour la conversion de fréquence, tels que des doubleurs (SHG) ou des tripleurs de fréquence (THG).

Dans le cadre de la présente invention, on utilise indifféremment les termes « solution de croissance cristalline », « solution de croissance », « solution de cristallisation » ou simplement « solution ».

L'évolution d'un cristal plongé dans une solution (solvant + soluté) dépend du niveau de saturation de la solution. Si la solution est sursaturée, c'est-à-dire si la quantité de sel dissous est plus importante que la quantité à l'équilibre, le cristal croit par consommation du sel en excès dans la solution. La vitesse de croissance du cristal dépend du niveau de sursaturation de la solution, qui peut être contrôlé par abaissement de la température, par évaporation du solvant ou par réalimentation de la solution en sel. La vitesse de croissance dépend aussi du renouvellement de la couche limite de solution située autour du cristal. *A contrario,* un cristal plongé dans une solution sous-saturée se dissout jusqu'à ce que la quantité de sel dissous dans la solution atteigne la quantité à l'équilibre. Il peut disparaître complètement.

Pour réaliser un monocristal dans une solution de croissance cristalline, on utilise une installation de croissance comprenant une cuve (également appelée cristallisoir), destinée à contenir la solution de cristallisation, ainsi qu'une plateforme de croissance, apte à être mise en rotation simple ou alternée dans la cuve. Le cristal se développe dans la solution sursaturée sur le plateau inférieur de la plateforme de croissance.

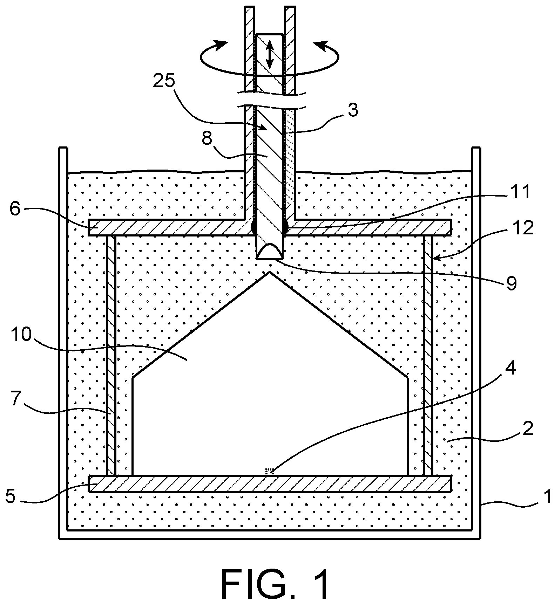

Un exemple d'une telle installation est illustré dans la figure 1 ci-jointe. Dans cette figure 1 sont représentés, de manière schématique, une cuve de croissance 1, contenant la solution de croissance 2, ainsi qu'une plateforme de croissance 12, suspendue dans la cuve par un arbre de rotation 3 creux, qui sert d'axe de rotation à la plateforme. Le germe 4 est collé au centre du plateau inférieur 5 de la plateforme. Le plateau inférieur 5 est relié à un plateau supérieur 6 par des piliers 7. Cette installation comporte également un système de protection 25 du germe, qui comprend une tige 8, qui est montée coulissante dans l'arbre de rotation 3 et qui possède, à sa base, un évidement 9. Cet évidement permet de protéger le germe durant les étapes de sous saturation de la solution. Le résultat de la croissance cristalline est le cristal 10. Un joint torique 11 assure l'étanchéité au niveau du jeu entre l'axe de l'arbre 3 et la tige 8.

Lors de la croissance en solution de monocristaux de très grande taille, la stabilité de la solution vis-à-vis de la germination est un facteur très important, car l'apparition puis le développement de cristaux parasites dans la solution réduit la croissance du cristal principal, voire entraine l'arrêt complet de sa croissance. En effet, la consommation du sel en solution par un cristal parasite réduit la masse accessible au cristal principal.

La germination est un processus correspondant à l'apparition, dans la solution de croissance, d'une nouvelle phase condensée. Il existe plusieurs types de germination, à savoir :
- la germination primaire homogène, qui correspond à l'apparition de germes au sein de la solution de croissance ;
- la germination primaire hétérogène, qui correspond à l'apparition de germes sur une surface en contact avec la solution de croissance ; et
- la germination secondaire, qui correspond à l'apparition de germes issus de cristaux déjà présents dans la solution de croissance.

Quelle que soit la nature de la germination, l'apparition de cristaux parasites dans la solution de croissance est une cause d'échec lors de la croissance de monocristaux de grandes dimensions.

C'est la raison pour laquelle de nombreuses précautions sont prises pour éviter la germination et le développement de cristaux parasites, comme notamment :
- le choix des matériaux composant la cuve, la plateforme et l'éventuel système de protection du germe de l'installation de croissance ;
- la qualité de l'état de surface des surfaces au contact de la solution de croissance ;
- la réalisation d'un prétraitement de la solution de croissance, à une température supérieure à la température de saturation ;
- la réalisation d'un traitement de filtration continue et externe à la cuve, par prélèvement et réinjection de la solution de croissance ; etc.

Malgré toutes ces précautions, une germination peut quand même se produire.

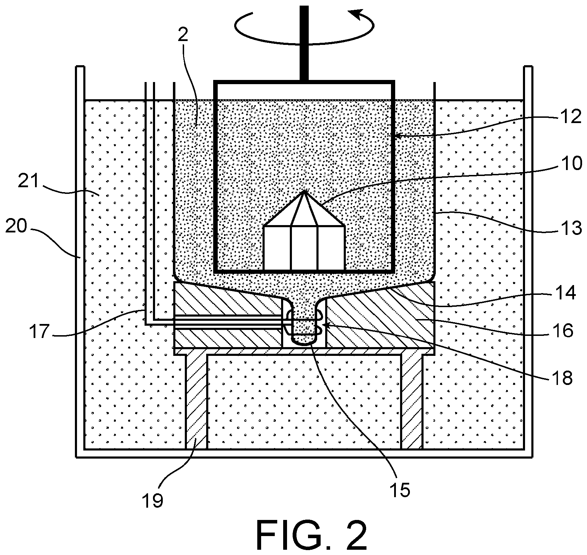

Afin de piéger et dissoudre les cristaux issus de la germination dans la solution de croissance, des auteurs proposent une installation particulière, illustrée dans la figure 2. Ici, la cuve 13 a une forme particulière avec un fond ayant une partie périphérique 14 à courbure convexe et une partie centrale 15 saillante en forme de puits. Le fond repose sur une épaisse plaque 16 d'isolant thermique ayant un trou dans lequel est inséré le puits. Un moyen de chauffage 17 sous la forme d'une bobine est placé autour du puits, dans la plaque, et permet, pendant la croissance cristalline, de maintenir le puits à une température de 2 à 3°C plus élevée que celle régnant dans la cuve 13. L'association de cette partie centrale 15 saillante en forme de puits, du moyen de chauffage et de la plaque 16 d'isolant thermique forme, dans le fond de la cuve 13, un piège central à cristaux 18. En effet, les éventuels cristaux parasites qui se forment au cours de la croissance vont se déplacer vers le puits du fait de la courbure du fond et y rester coincés en raison de la température plus élevée qui y règne. La cuve 13 est en outre placée sur un trépied 19 dans un récipient 20 rempli de liquide 21. Des méthodes similaires sont décrites dans les documents [1] et [2]. D'autre part, les auteurs du document [3] divulguent un procédé de croissance de KDP en solution comprenant une cuve et un support pour germe où la solution sursaturée est filtrée pour éviter l'apparition de germes ou cristaux parasites.

L'inconvénient de cette solution est qu'elle nécessite un équipement particulier, avec notamment une cuve avec un fond avec une partie saillante, un moyen de chauffage et une plaque d'isolant thermique.

### REFERENCES CITEES

[1] US 5,904,772
[2] Nucleation-trap crystallizer for growth of crystals from solutions » de A.K. Karnal et al., Journal of Crystal Growth 297 (2006) pages 152-156
[3] US 5 122 224

### EXPOSÉ DE L'INVENTION

La présente invention vise à limiter les effets de la germination de cristaux dans une solution de croissance sursaturée, tout en simplifiant l'équipement nécessaire à la croissance de monocristaux sans cristaux parasites.

On atteint ce but de l'invention, ainsi que d'autres qui apparaîtront à la lumière de la description qui va suivre, avec un procédé de fabrication d'un monocristal par croissance en solution à partir d'un germe cristallin, mis en œuvre à l'aide d'une installation comprenant :
- une cuve, destinée à contenir la solution de croissance cristalline ;
- une plateforme de croissance, apte à être mise en rotation dans la cuve, et comprenant un plateau inférieur, sur lequel le monocristal est destiné à se développer ;
le procédé comprenant :
- la fixation du germe cristallin sur le plateau inférieur de la plateforme de croissance ;
- l'introduction de la solution de cristallisation dans la cuve ;
- le traitement de la solution pour la rendre sursaturée ;
- la mise en contact du germe cristallin avec la solution sursaturée ; et
- la mise en rotation de la plateforme jusqu'à l'obtention du monocristal ;
le procédé étant caractérisé en ce qu'il comprend en outre, avant la mise en contact du germe cristallin avec la solution sursaturée, la formation, dans la cuve, d'une zone de piégeage de cristaux parasites susceptibles de croître dans la solution de croissance cristalline, par introduction, dans la cuve, d'un liquide non miscible avec la solution de croissance, ce liquide ayant une densité supérieure à la densité de la solution de croissance et inférieure à la densité des cristaux parasites et formant avec la solution de croissance une interface qui est située en dessous du plateau inférieur de la plateforme de croissance.

Le fait, d'une part, qu'on choisisse d'introduire un liquide qui soit immiscible avec la solution de cristallisation et qui ait une telle densité et le fait, d'autre part, que l'interface de la solution cristalline avec le liquide soit située en dessous du plateau inférieur sur lequel se développe le monocristal font que les cristaux parasites se déplacent par gravité vers le fond de la cuve de croissance et restent piégés dans la zone de piégeage, ne gênant pas la croissance du monocristal.

On précise que les étapes d'introduction de la solution de cristallisation et du liquide non miscible peuvent être concomittantes ou successives, le liquide immiscible pouvant être introduit avant, après ou en même temps que la solution de cristallisation.

De préférence, le liquide qui est non miscible avec la solution de croissance a une composition chimique qui ne permet pas une croissance des cristaux parasites.

Avantageusement, lorsque l'installation comprend un organe de protection du germe cristallin, le procédé comprend en outre :
- après la fixation du germe cristallin sur le plateau inférieur de la plateforme de croissance, et avant l'introduction de la solution de cristallisation dans la cuve, la mise en place de l'organe de protection autour du germe et son maintien sur le plateau inférieur de la plateforme de croissance ; et
- après l'introduction de la solution de cristallisation et l'introduction du liquide immiscible dans la cuve, et avant le traitement de la solution pour la rendre sursaturée, les opérations de :
   - mise en contact de l'organe de protection avec la solution de cristallisation par immersion du plateau inférieur de la plateforme de croissance dans la solution de cristallisation ;
   - traitement de la solution de cristallisation pour la rendre sous-saturée ;
   - mise en contact du germe avec la solution de cristallisation sous-saturée en éloignant l'organe de protection du plateau inférieur.

Les étapes de traitement pour rendre la solution sursaturée ou sous-saturée sont connues de l'homme du métier et ne sont pas décrites ici. Si la solubilité de la solution de cristallisation est croissante avec la température, ces étapes peuvent par exemple consister en une modification de la température de la solution de cristallisation, à savoir une augmentation de la température pour obtenir une solution sous-saturée ou une diminution de la température pour obtenir une solution sursaturée. À l'inverse, dans le cas, plus rare, d'un couple soluté/solvant à solubilité décroissante avec la température, on augmentera la température pour sursaturer la solution.

La solution de croissance cristalline peut par exemple être un milieu aqueux ou un solvant organique.

Avantageusement, la solution de croissance cristalline est un milieu aqueux et le liquide immiscible est choisi parmi les polyéthers perfluorés et les perfluorocarbures.

Le procédé selon l'invention permet de limiter les effets de la germination primaire ou secondaire dans une solution de croissance cristalline, et plus particulièrement dans une solution de croissance cristalline en milieu aqueux. Le procédé permet notamment de stopper le développement de germes parasites dans un milieu tel qu'une solution sursaturée en sel.

L'invention concerne également l'utilisation du procédé de fabrication telle que décrit ci-dessus pour la fabrication d'un monocristal de KDP ou de DKDP.

### BRÈVE DESCRIPTION DES DESSINS

L'invention sera mieux comprise et d'autres avantages et particularités apparaitront à la lecture de la description qui va suivre, donnée à titre d'exemple non limitatif, accompagnée des dessins annexés parmi lesquels :
- la figure 1, déjà décrite, est une vue schématique d'un exemple d'installation de croissance utilisée dans l'art antérieur ;
- la figure 2 est une vue schématique d'un autre exemple d'installation de croissance de l'art antérieur, configurée pour limiter les effets de la germination au cours de la croissance en solution ;
- la figure 3 est une vue schématique de l'installation de croissance illustrée dans la figure 1, mettant en œuvre le procédé de fabrication selon l'invention, afin de limiter les effets de la germination durant la croissance en solution.

Sur l'ensemble de ces figures, des références identiques ou analogues désignent des éléments ou ensembles d'éléments identiques ou analogues.

### EXPOSÉ DÉTAILLÉ DE MODES DE RÉALISATION PARTICULIERS

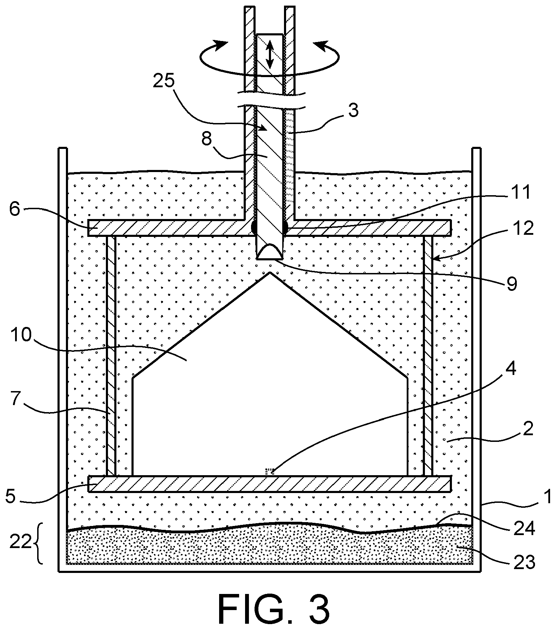

Un exemple d'installation de croissance avec laquelle le procédé selon l'invention peut être mise en œuvre est illustré dans la figure 3. L'installation est la même que celle décrite dans la figure 1. On a ainsi, dans la cuve 1, une plateforme de croissance 12, une solution de croissance 2 et un cristal en croissance 10. La solution de croissance 2. et le cristal en croissance 10 forment respectivement une première phase (liquide) et une deuxième phase (solide). Conformément au procédé selon l'invention, on introduit également dans la cuve un liquide 21, qui est immiscible avec la solution de croissance 2 ; la cuve 1 contient donc également une troisième phase (liquide), qui forme une zone de piégeage 22 des cristaux parasites.

La masse volumique de ce liquide immiscible 21 est choisie supérieure à celle de la solution de croissance 2, de sorte à ce qu'il couvre le fond de la cuve 1. En outre, la quantité de liquide immiscible introduite dans la cuve est telle que l'interface 24 entre le liquide immiscible 21 et la solution de croissance 2 est située sous le plateau inférieur 5 de la plateforme de croissance.

Par ailleurs, le liquide 21 qui est immiscible avec la solution de croissance 2 est choisi pour que sa masse volumique soit inférieure à celle des cristaux issus de la germination, de sorte à ce que ces cristaux soient piégés dans ce liquide par gravité.

Le germe parasite ayant une masse volumique plus élevée que celle de la solution de croissance, la gravité l'entraine au fond de la cuve jusqu'à l'interface entre la solution de croissance et le liquide immiscible. La masse volumique du germe étant plus élevée que celle du liquide immiscible, situé au fond de la cuve, il traverse l'interface pour être piégé dans le liquide immiscible, dans lequel il n'évolue plus durant la poursuite de la croissance du cristal sur le plateau inférieur de la plateforme.

La quantité de liquide immiscible introduite dans la cuve est un compromis entre avoir une zone de piégeage ayant une hauteur minimale apte à piéger tous les éventuels cristaux parasites et avoir un volume maximal de solution cristalline dans la cuve dédié à la croissance du monocristal.

En croissance rapide en solution sursaturée, dans une installation de croissance pour la production de très grands cristaux de KDP par exemple, le germe est un cube d'environ 1 cm de côté plongé dans une solution de croissance de plusieurs litres, voire dizaines ou centaines de litres.

L'installation de croissance illustrée dans la figure 3 comporte un organe de protection 25 du germe. Pour réaliser un monocristal conformément au procédé selon l'invention, on peut utiliser une telle installation.

Selon un mode de réalisation du procédé conformément à l'invention, on fixe le germe cristallin 4 sur le plateau inférieur 5 de la plateforme de croissance ; puis on met en place l'organe de protection autour du germe en maintenant la tige 8 en contact avec le plateau inférieur 5 de manière à ce que le germe soit contenue dans l'évidement 9 ; puis on introduit la solution de cristallisation 2 dans la cuve ; on verse ensuite dans la cuve un liquide immiscible 21, de manière à former la zone de piégeage 22 de cristaux parasites; on met en contact l'organe de protection avec la solution de cristallisation en immergeant le plateau inférieur (5) de la plateforme de croissance dans la solution de cristallisation; on met en rotation la plateforme 12; on procède au traitement de la solution de cristallisation pour la rendre sous-saturée ; on met en contact le germe avec la solution de cristallisation sous-saturée en éloignant l'organe de protection 25 du plateau inférieur; avant la disparition complète du germe, on procède au traitement de la solution pour la rendre sursaturée ; on maintient la rotation de la plateforme dans la solution sursaturée jusqu'à obtenir le monocristal souhaité.

Selon un exemple de réalisation, pour réaliser un monocristal de dihydrogénophosphate de potassium (KDP), on verse dans une cuve 800 litres de solution de KDP (solution de croissance, le solvant étant de l'eau) ayant une densité de 1,3 et 50 litres de polyéther perfluoré (PFPE) (liquide immiscible), qui est immiscible avec la solution de croissance, et a une densité de l'ordre de ou supérieure à 1,8. La densité des parasites, dans le cas du KDP, est de l'ordre de 2,35. La densité du liquide immiscible est effectivement choisie supérieure à la densité de la solution de croissance et inférieure à celle des cristaux parasites.

Le procédé selon l'invention présente de nombreux avantages. Il permet de limiter les effets de la germination de cristaux dans une solution de croissance sursaturée au cours de la croissance d'un monocristal, sans nécessiter de modifications matérielles de l'installation de croissance, et notamment de la cuve. Il permet en effet la poursuite de la croissance du monocristal, malgré la présence, dans la solution de croissance, d'une source de germination autre que le germe initial du monocristal. Au final, le procédé selon l'invention permet de fiabiliser la fabrication de monocristaux de grandes dimensions.

## Revendications

1. Procédé de fabrication d'un monocristal (10) par croissance en solution à partir d'un germe cristallin (4), mis en œuvre à l'aide d'une installation comprenant :
- une cuve (1), destinée à contenir la solution de croissance cristalline (2) ;
- une plateforme de croissance (12), apte à être mise en rotation dans la cuve, et comprenant un plateau inférieur (5), sur lequel le monocristal est destiné à se développer;
le procédé comprenant :
- la fixation du germe cristallin (4) sur le plateau inférieur (5) de la plateforme de croissance ;
- l'introduction de la solution de cristallisation (2) dans la cuve ;
- le traitement de la solution pour la rendre sursaturée ;
- la mise en contact du germe cristallin (4) avec la solution sursaturée ; et
- la mise en rotation de la plateforme (12) jusqu'à l'obtention du monocristal ;
le procédé étant **caractérisé en ce qu'**il comprend en outre, avant la mise en contact du germe cristallin avec la solution sursaturée, la formation, dans la cuve, d'une zone de piégeage (22) de cristaux parasites susceptibles de croître dans la solution de croissance cristalline, par introduction, dans la cuve, d'un liquide (21) non miscible avec la solution de croissance (2), ce liquide ayant une densité supérieure à la densité de la solution de croissance et inférieure à la densité des cristaux parasites et formant avec la solution de croissance une interface (24) qui est située en dessous du plateau inférieur (5) de la plateforme de croissance.

2. Procédé selon la revendication 1, dans lequel l'installation comprenant un organe de protection (25) du germe cristallin, le procédé comprend en outre :
- après la fixation du germe cristallin sur le plateau inférieur de la plateforme de croissance, et avant la mise en contact du germe cristallin avec la solution sursaturée, la mise en place de l'organe de protection (25) autour du germe (4) et son maintien sur le plateau inférieur (5) de la plateforme de croissance ; et
- après les introductions de la solution de cristallisation (2) et du liquide immiscible (21) dans la cuve, et avant le traitement de la solution (2) pour la rendre sursaturée, les opérations successives de :
• traitement de la solution pour la rendre sous-saturée ;
• mise en contact de l'organe de protection avec la solution de cristallisation sous-saturée par immersion du plateau inférieur de la plateforme de croissance dans la solution de cristallisation sous-saturée ;
• mise en contact du germe avec la solution de cristallisation sous-saturée en éloignant l'organe de protection (25) du plateau inférieur.

3. Procédé selon la revendication 1 ou la revendication 2, dans lequel la solution de croissance cristalline est un milieu aqueux et le liquide immiscible est choisi parmi les polyéthers perfluorés et les perfluorocarbures.

4. Procédé selon l'une quelconque des revendications 1 à 3, dans lequel le monocristal est un monocristal de dihydrogénophosphate de potassium (KDP) ou de dihydrogénophosphate de potassium deutéré (DKDP).

## Patentansprüche

1. Verfahren zur Herstellung eines Einkristalls (10) durch Wachstum in Lösung aus einem Kristallkeim (4) das mithilfe einer Anlage durchgeführt wird, umfassend:
- einen Tank (1), der dazu vorgesehen ist, die Kristallwachstumslösung (2) zu enthalten;
- eine Wachstumsplattform (12), die dazu geeignet ist, in dem Tank in Drehung versetzt zu werden, und umfassend eine untere Platte (5), auf der der Einkristall sich entwickeln soll;
wobei das Verfahren umfasst:
- Fixieren des Kristallkeims (4) auf der unteren Platte (5) der Wachstumsplattform;
- Einbringen der Kristallisationslösung (2) in den Tank;
- Behandeln der Lösung zum Übersättigen dieser;
- Inkontaktbringen des Kristallkeims (4) mit der übersättigten Lösung und
- Indrehungversetzen der Plattform (12) bis zum Erhalt des Einkristalls;
wobei das Verfahren **dadurch gekennzeichnet ist, dass** es weiterhin vor dem Inkontaktbringen des Kristallkeims mit der übersättigten Lösung ein Bilden einer Einfangzone (22) für parasitäre Kristalle, deren Wachstum in der Kristallwachstumslösung wahrscheinlich ist, in dem Tank durch Einbringen einer Flüssigkeit (21), die mit der Wachstumslösung (2) nicht mischbar ist, in den Tank umfasst, wobei diese Flüssigkeit eine Dichte aufweist, die höher als die Dichte der Wachstumslösung und niedriger als die Dichte von parasitären Kristallen ist, und mit der Wachstumslösung eine Grenzfläche (24) bildet, die sich unter der unteren Platte (5) der Wachstumsplattform befindet.

2. Verfahren nach Anspruch 1, wobei die Anlage ein Schutzelement (25) für den Kristallkeim umfasst, wobei das Verfahren weiterhin umfasst:
- nach dem Fixieren des Kristallkeims auf der unteren Platte der Wachstumsplattform und vor dem Inkontaktbringen des Kristallkeims mit der übersättigten Lösung ein Anordnen des Schutzelements (25) um den Keim (4) und dessen Halten auf der unteren Platte (5) der Wachstumsplattform und
- nach dem Einbringen der Kristallisationslösung (2) und der unmischbaren Lösung (21) in den Tank und vor dem Behandeln der Lösung (2) zum Übersättigen dieser die sukzessiven Vorgänge:
• Behandeln der Lösung zum Untersättigen dieser;
• Inkontaktbringen des Schutzelements mit der untersättigten Kristallisationslösung durch Eintauchen der unteren Platte der Wachstumsplattform in die untersättigte Kristallisationslösung;
• Inkontaktbringen des Keims mit der untersättigten Kristallisationslösung, indem das Schutzelement (25) von der unteren Platte entfernt wird.

3. Verfahren nach Anspruch 1 oder Anspruch 2, wobei die Kristallwachstumslösung ein wässriges Medium ist und die unmischbare Flüssigkeit aus perfluorierten Polyethern und Perfluorcarbiden ausgewählt ist.

4. Verfahren nach einem der Ansprüche 1 bis 3, wobei der Einkristall ein Einkristall von Kaliumdihydrogenphosphat (KDP) oder von deuteriertem Kaliumdihydrogenphosphat (DKDP) ist.

## Claims

1. Process for manufacturing a single crystal (10) by solution growth from a seed crystal (4), implemented using an installation comprising:
- a vessel (1), intended to contain the crystal growth solution (2);
- a growth platform (12), capable of being rotated in the vessel, and comprising a lower tray (5), on which the single crystal is intended to grow;
the process comprising:
- bonding the seed crystal (4) to the lower tray (5) of the growth platform;
- introducing the crystallization solution (2) into the vessel;
- treating the solution to make it supersaturated;
- bringing the seed crystal (4) into contact with the supersaturated solution; and
- rotating the platform (12) until the single crystal is obtained;
the process being **characterized in that** it further comprises, prior to bringing the seed crystal into contact with the supersaturated solution, forming, in the vessel, a trapping zone (22) for parasitic crystals likely to grow in the crystal growth solution, by introduction, into the vessel, of a liquid (21) immiscible with the growth solution (2), this liquid having a density greater than the density of the growth solution and lower than the density of the parasitic crystals and forming with the growth solution an interface (24) which is located below the lower tray (5) of the growth platform.

2. Process as claimed in claim 1, wherein the installation comprises a seed crystal protection member (25), the process further comprises:
- after bonding the seed crystal to the lower tray of the growth platform, and before bringing the seed crystal into contact with the supersaturated solution, placing the protective member (25) around the seed crystal (4) and holding it on the lower tray (5) of the growth platform; and
- after introducing the crystallization solution (2) and the immiscible liquid (21) into the vessel, and before treating the solution (2) to make it supersaturated, the successive operations of:
• treating the solution to make it undersaturated;
• bringing the protective member into contact with the undersaturated crystallization solution by immersion of the lower tray of the growth platform in the undersaturated crystallization solution;
• bringing the seed into contact with the undersaturated crystallization solution by moving the protective member (25) away from the lower tray.

3. Process as claimed in claim 1 or claim 2, wherein the crystal growth solution is an aqueous medium and the immiscible liquid is selected from perfluoropolyethers and perfluorocarbons.

4. Process as claimed in any one of claims 1 to 3, wherein the single crystal is a single crystal of potassium dihydrogen phosphate (KDP) or of deuterated potassium dihydrogen phosphate (DKDP).
